# EUROPEAN PATENT SPECIFICATION

(11) **EP 3 983 229 B1**
(45) Date of publication and mention of the grant of the patent: **02.08.2023**
(21) Application number: 20751704.6
(22) Date of filing: 11.06.2020
(51) Int. Cl.: B41F 15/44, B41F 15/34, B41F 15/40, B41F 15/08, H05K 3/12

(54) **AUTOMATED PRINTER ROBOTIC ARM**
AUTOMATISCHER DRUCKERROBOTERARM
BRAS ROBOTIQUE D'IMPRIMANTE AUTOMATISÉ

(30) Priority: 13.06.2019 US 201962861025 P; 13.06.2019 US 201962861031 P; 13.06.2019 US 201962861035 P; 10.06.2020 US 202016897493
(43) Date of publication of application: 20.04.2022
(73) Proprietor: Illinois Tool Works Inc., Glenview, IL 60025 (US)
(72) Inventor: LYNCH, James, Glenview, IL 60025 (US); SCHUMACHER, Matthew F., Glenview, IL 60025 (US); SEATON, Bruce C., Glenview, IL 60025 (US); WANG, Weidong, Glenview, IL 60025 (US)
(74) Representative: HGF
(86) International application number: PCT/US2020/037131
(87) International publication number: WO 2020/252100

(56) References cited:
- CN-U- 207 266 515
- JP-A- H04 197 684
- JP-A- 2000 103 031
- US-A1- 2002 020 346

## Description

### BACKGROUND OF THE DISCLOSURE

### 1. Field of Invention

This application relates generally to stencil printers and related methods to print viscous materials, e.g., solder paste, on an electronic substrate, e.g., a printed circuit board (PCB), and more particularly to systems and methods for fully automating such stencil printers and methods.

### 2. Discussion of Related Art

In manufacturing a surface-mount printed circuit board, a stencil printer can be used to print solder paste onto the circuit board. Typically, a circuit board having a pattern of pads or some other conductive surface onto which solder paste will be deposited is automatically fed into the stencil printer; and one or more small holes or marks (known as "fiducials") on the circuit board are used to properly align the circuit board with the stencil or screen of the stencil printer prior to printing solder paste onto the circuit board. In some systems, an optical alignment system embodying a vision system is used to align the circuit board with the stencil. JP2000103031 discloses a stencil printer with a robotic arm to changeover items in said stencil printer.

Once the circuit board has been properly aligned with the stencil in the printer, the circuit board is raised to the stencil, solder paste is dispensed onto the stencil, and a wiper blade (or squeegee) traverses the stencil to force the solder paste through apertures in the stencil and onto the circuit board. As the squeegee is moved across the stencil, the solder paste tends to roll in front of the blade, which desirably causes mixing and shearing of the solder paste so as to attain a desired viscosity to facilitate filling of the apertures in the screen or stencil. The solder paste typically is dispensed onto the stencil from a standard cartridge. The stencil is then separated from the circuit board and the adhesion between the circuit board and the solder paste causes most of the material to stay on the circuit board. Material left on the surface of the stencil is removed in a cleaning process before additional circuit boards are printed.

Another process in the printing of circuit boards involves inspection of the circuit boards after solder paste has been deposited on the surface of the circuit boards. Inspecting the circuit boards is important for determining that clean electrical connections can be made. An excess of solder paste can lead to shorts, while too little solder paste in appropriate positions can prevent electrical contact. Generally, the vision inspection system is further employed to provide a two-dimensional or a three-dimensional inspection of the solder paste on the circuit board.

Present day stencil printers require manual intervention to perform routine operations. For example, during a changeover, an operator must perform many manual tasks, such as changing a stencil, replacing a solder paste cartridge, replacing squeegee blades, and replacing support tooling. Each of these tasks require the operator to manually perform the task. For example, with most stencil printers, the operator must unlock the stencil, remove the stencil, properly insert a replacement stencil, and lock the replacement stencil in place. A changeover operation can take as long as 30 minutes, during which the stencil printer is not operating, which may result in the PCB fabrication line not operating.

Stencil printers further require manual intervention to perform replacement and/or replenishment operations. For example, solder paste cartridges, which supply temperature-controlled solder paste to the stencil printer, require replacement over time, e.g., within four hours or less. Items subject to normal wear and tear, such as squeegee blades and stencils, may require periodic replacement when damaged.

The invention is defined by independent claim 1 and preferred embodiments are defined in the dependent claims.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a perspective view of a stencil printer;
FIG. 2 is a front view of a stencil printer;
FIG. 3 is a top plan view of the stencil printer illustrated in FIG. 2 with portions removed;
FIG. 4 is a diagram showing a method of replacing a stencil within a stencil printer;
FIG. 5 is a diagram showing a method of replacing a paste cartridge within a stencil printer;
FIG. 6 is a diagram showing a method of replacing squeegee blades within a stencil printer;
FIG. 7 is a diagram showing a method of replacing tooling used to support substrates within a stencil printer;
FIG. 8 is a schematic view of a movable cart of an embodiment of the present disclosure, the movable cart being proximate to a stencil printer;
FIG. 9 is a schematic view of the movable cart being configured to deliver and receive stencils to and from the stencil printer;
FIG. 10 is a schematic view of the movable cart being configured to deliver and receive items to and from the stencil printer;
FIG. 11 is a schematic view of the movable cart being configured to deliver and receive items to and from the stencil printer;
FIG. 12 is a schematic view of the movable cart being configured to deliver and receive tooling to and from the stencil printer;
FIG. 13 is a perspective schematic view of a robotic arm of an embodiment of the disclosure, the robotic arm being configured to manipulate a squeegee blade having two blades;
FIG. 14 is a perspective schematic view of a blade;
FIG. 15 is another schematic view of a robotic arm of an embodiment of the disclosure;
FIG. 16 is a schematic view of a robotic arm of an embodiment of the disclosure, the robotic arm being mounted within the stencil printer;
FIG. 17 is a schematic view of a robotic arm of an embodiment of the disclosure, the robotic arm being mounted at a different location within the stencil printer; and
FIG. 18 is a schematic view of a robotic arm of another embodiment of the disclosure, the robotic arm being mounted at a location outside the stencil printer.

### DETAILED DESCRIPTION OF THE DISCLOSURE

The present disclosure relates generally to material application machines (referred to herein as "stencil printers," "screen printers," "printing machines," or "printers") and other equipment utilized in a surface mount technology (SMT) process lines and configured to apply an assembly material (e.g., solder paste, conductive ink, or encapsulation material) onto a substrate (e.g., a printed circuit board, referred to herein as an "electronic substrate," a "circuit board," a "board," a "PCB," a "PCB substrate," a "substrate," or a "PCB board") or to perform other operations, such as inspection, rework, or placement of electronic components onto a substrate. Specifically, embodiments of the present disclosure are described below with reference to stencil printers used to produce printed circuit boards.

For the purposes of illustration only, and not to limit the generality, the present disclosure will now be described in detail with reference to the accompanying figures. This disclosure is not limited in its application to the details of construction and the arrangement of components set forth in the following description or illustrated in the drawings. The principles set forth in this disclosure are capable of other embodiments and of being practiced or carried out in various ways. Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements.

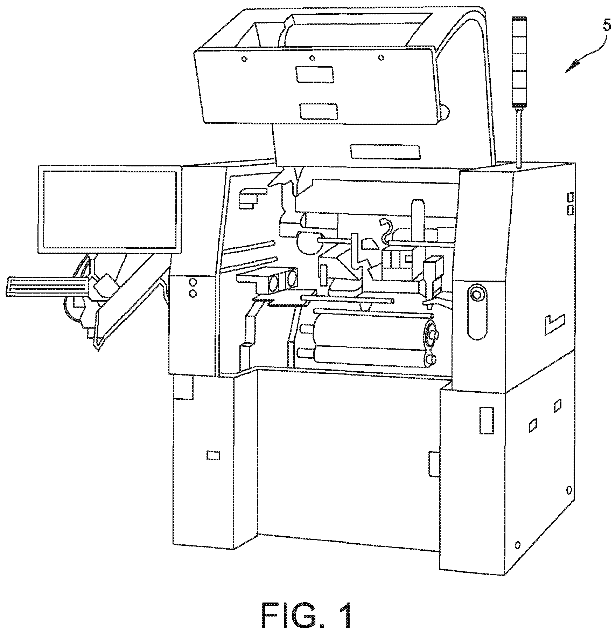

For purposes of illustration, embodiments of the present disclosure will now be described with reference to a stencil printer used to print an assembly material, such as solder paste, onto a circuit board. One skilled in the art will appreciate, however, that embodiments of the present disclosure are not limited to stencil printers that print solder paste onto circuit boards, but rather, may be used in other applications requiring dispensing of other viscous assembly materials, such as glues and encapsulents. For example, the apparatus may be used to print epoxy for use as underfill for chip-scale packages. Further, stencil printers in accordance with embodiments of the present disclosure are not limited to those that print assembly materials on circuit boards, but rather, include those used for printing other materials on a variety of substrates, such as semiconductor wafers. Also, the terms screen and stencil may be used interchangeably herein to describe a device in a printer that defines a pattern to be printed onto a substrate. In certain embodiments, the stencil printer may include a Momentum^{®} or an Edison^{™} series stencil printer platform offered by ITW Electronic Assembly Equipment of Hopkinton, Massachusetts. An exemplary stencil printer is generally designated at 5 in FIG. 1. In this embodiment, the stencil printer 5 is a Momentum^{®} series stencil printer platform offered by ITW Electronic Assembly Equipment of Hopkinton, Massachusetts.

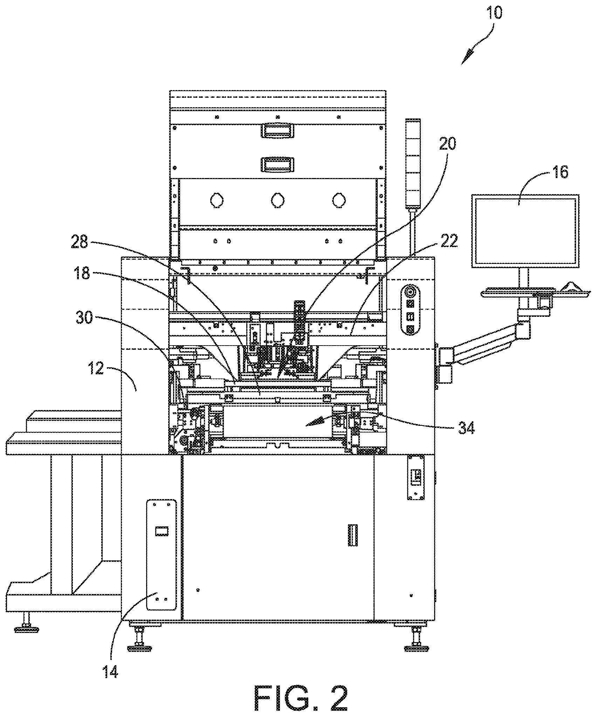

Referring to FIG. 2, there is generally indicated at 10 a stencil printer of an embodiment of the disclosure. As shown, the stencil printer 10 includes a frame 12 that supports components of the stencil printer. The components of the stencil printer may include, in part, a controller 14, a display 16, a stencil 18, and a print head or print head assembly, generally indicated at 20, which is configured to apply the solder paste in a manner described in greater detail below.

As shown in FIG. 2 and described below, the stencil and the print head assembly may be suitably coupled or otherwise connected to the frame 12. In one embodiment, the print head assembly 20 may be mounted on a print head assembly gantry 22, which may be mounted on the frame 12. The print head assembly gantry 22 enables the print head assembly 20 to be moved in the y-axis direction under the control of the controller 14 and to apply pressure on the print head assembly as it engages the stencil 18. In a certain embodiment, the print head assembly 20 may be placed over the stencil 18 and may be lowered in the z-axis direction into contact and sealingly engage the stencil.

The stencil printer 10 may also include a conveyor system having rails (not shown) for transporting a printed circuit board (sometimes referred to as a "printed wiring board," "substrate," or "electronic substrate" herein) to a print position in the stencil printer. The rails sometimes may be referred to herein as a "tractor feed mechanism," which is configured to feed, load or otherwise deliver circuit boards to the working area of the stencil printer, which may be referred to herein as a "print nest," and to unload circuit boards from the print nest.

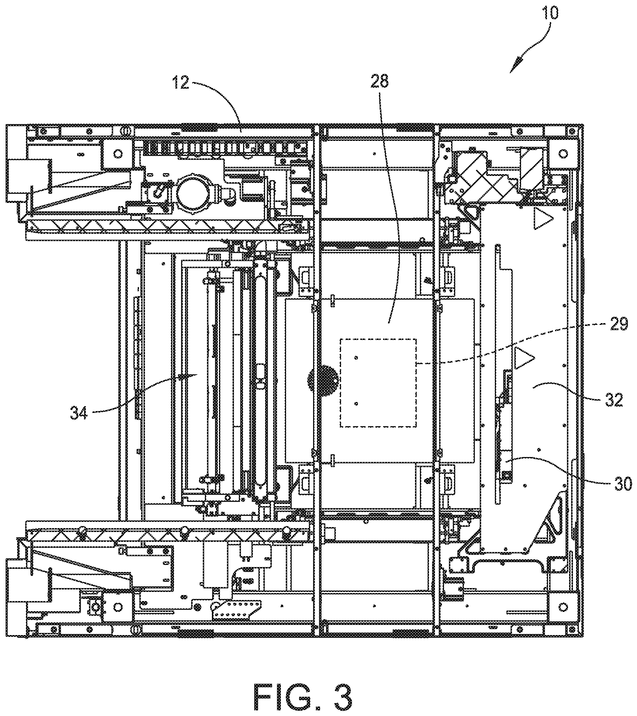

Referring additionally to FIG. 3, the stencil printer 10 has a support assembly 28 to support the circuit board 29 (shown in dashed lines), which raises and secures the circuit board so that it is stable during a print operation. In certain embodiments, the substrate support assembly 28 further may include a particular substrate support system, e.g., a solid support, a plurality of pins or flexible tooling, which is positioned beneath the circuit board when the circuit board is in the print position. The substrate support system may be used, in part, to support the interior regions of the circuit board to prevent flexing or warping of the circuit board during the print operation.

In one embodiment, the print head assembly 20 may be configured to receive solder paste from a source, such as a dispenser, e.g., a solder paste cartridge, that provides solder paste to the print head assembly during the print operation. Other methods of supplying solder paste may be employed in place of the cartridge. For example, solder paste may be manually deposited between the blades or from an external source. Additionally, in a certain embodiment, the controller 14 may be configured to use a personal computer having a suitable operating system, such as a Microsoft Windows^{®} operating system provided by Microsoft Corporation, with application specific software to control the operation of the stencil printer 10. The controller 14 may be networked with a master controller that is used to control a production line for fabricating circuit boards.

In one configuration, the stencil printer 10 operates as follows. A circuit board 29 is loaded into the stencil printer 10 using the conveyor rails. The support assembly 28 raises and secures the circuit board 29 to a print position. The print head assembly 20 is then lowered in the z-axis direction until blades of the print head assembly contact the stencil 18 at a desired pressure. The print head assembly 20 is then moved in the y-axis direction across the stencil 18 by the print head assembly gantry 22. The print head assembly 20 deposits solder paste through apertures in the stencil 18 and onto the circuit board 29. Once the print head assembly has fully traversed the stencil 18 across the apertures, the print head assembly is lifted off the stencil and the circuit board 29 is lowered back onto the conveyor rails. The circuit board 29 is released and transported from the stencil printer 10 so that a second circuit board may be loaded into the stencil printer. To print on the second circuit board 29, the print head assembly is lowered in the z-axis direction into contact with the stencil and moved across the stencil 18 in the direction opposite to that used for the first circuit board.

An imaging system 30 may be provided for the purposes of aligning the stencil 18 with the circuit board 29 prior to printing and to inspect the circuit board after printing. In one embodiment, the imaging system 30 may be disposed between the stencil 18 and the support assembly 28 upon which a circuit board is supported. The imaging system 30 is coupled to an imaging gantry 32 to move the imaging system. In one embodiment, the imaging gantry 32 may be coupled to the frame 12, and includes a beam that extends between side rails of the frame 12 to provide back and forth movement of the imaging system 30 over the circuit board 29 in a y-axis direction. The imaging gantry 32 further may include a carriage device, which houses the imaging system 30, and is configured to move along the length of the beam in an x-axis direction. The construction of the imaging gantry 32 used to move the imaging system 30 is well known in the art of solder paste printing. The arrangement is such that the imaging system 30 may be located at any position below the stencil 18 and above the circuit board 29 to capture an image of predefined areas of the circuit board or the stencil, respectively.

After one or more applications of the solder paste to circuit boards, excess solder paste may accumulate at the bottom of the stencil 18 and a stencil wiper assembly, generally indicated at 34, and may move beneath the stencil to remove the excess solder paste. In other embodiments, the stencil 18 may be moved over the stencil wiper assembly.

### Automated Changeover and Replacement within a Stencil Printer

As mentioned above, stencil printers require manual intervention to perform replacement of certain parts and/or replenishment operations. For example, a typical stencil requires replacement after a certain period of time, e.g., four hours. Also, stencils need replacement for separate production runs. In addition, solder paste cartridges, which supply temperature-controlled solder paste to the stencil printer, require replacement over time, e.g., within four hours or less. A separate production run may require a different solder paste material. Another item requiring periodic replacement is squeegee blades, which are subject to wearing during use. And finally, tooling used to support a substrate in a print position is subject to replacement when changing from one production product to another.

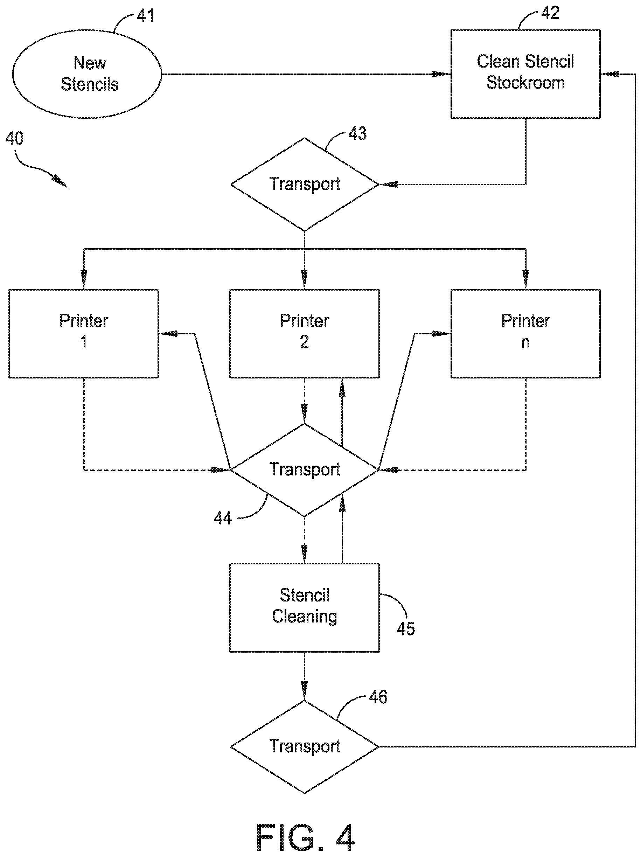

Referring to FIG. 4, a method of replacing a stencil is generally designated at 40. Stencils are used to print solder paste onto a printed circuit board. Stencils are often fabricated from stainless steel or nickel. As shown, when a request for a new stencil is made at 41, either for a new production run or because of wear on an existing stencil, a clean stencil is retrieved from a stencil stockroom at 42 and transported at 43 to one of several stencil printers identified by "Printer 1," "Printer 2" and "Printer 3." The stencil printers can be part of a single production line used to fabricate printed circuit boards or part of several production lines. The number of stencil printers can vary. At the production line, the "dirty" or used stencil is removed from the stencil printer and the "clean" or new stencil is inserted into the stencil printer and secured for use. The dirty stencil is transported at 44 to a stencil cleaning station 45 where the stencil is cleaned and ready for reuse. Once cleaned, the stencil is transported back at 46 to the clean stencil stockroom 42, where the stencil is ready to be reused during the same or different production run.

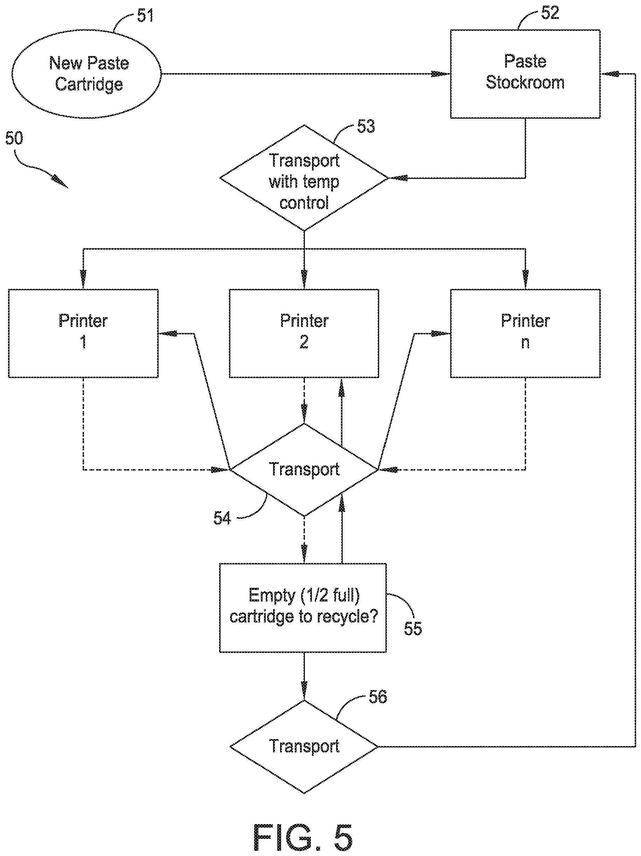

Referring to FIG. 5, a method of replacing a paste cartridge is generally designated at 50. As shown, when a request for a new paste cartridge is made at 51, either for a new production run or because of exhaustion of an existing paste cartridge, a new paste cartridge is retrieved from a paste cartridge stockroom at 52 and transported at 53 to one of several stencil printers identified by "Printer 1," "Printer 2" and "Printer 3." The stencil printers can be part of a single production line used to fabricate printed circuit boards or part of several production lines. The number of stencil printers can vary. In this embodiment, the storage of the paste cartridges in the stockroom 52 and the transportation of the paste cartridge at 53 should take place in a temperature- and/or climate-controlled environment suitable to preserve the solder paste contained within the solder paste cartridges. At the production line, the "spent" or used paste cartridge is removed from the stencil printer and the "full" or new paste cartridge is inserted into the stencil printer and secured for use. The spent paste cartridge is transported at 54 to a station 55 where the paste cartridge is saved (because it is not completely used) or saved for recycling. Once saved or recycled, the paste cartridge is transported back at 56 to the paste cartridge stockroom 52, where the paste cartridge is ready to be used during the same or different production run.

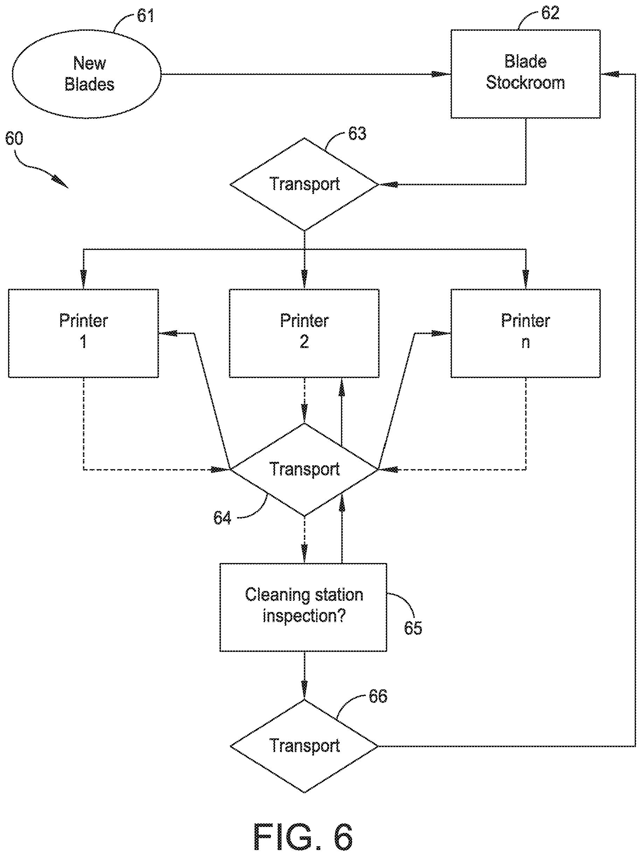

Referring to FIG. 6, a method of replacing a squeegee blade or a pair of squeegee blades is generally designated at 60. As shown, when a request for a new squeegee blade is made at 61, either for a new production run or because of a defect detected with an existing squeegee blade, a new squeegee blade is retrieved from a squeegee blade stockroom at 62 and transported at 63 to one of several stencil printers identified by "Printer 1," "Printer 2" and "Printer 3." The stencil printers can be part of a single production line used to fabricate printed circuit boards or part of several production lines. The number of stencil printers can vary. At the production line, the used squeegee blade is removed from the stencil printer and the new squeegee blade is inserted into the stencil printer and secured for use. The used squeegee blade is transported at 64 to a station 65 where the squeegee blade is inspected, and if salvageable, cleaned for reuse. If defective, the squeegee blade is scrapped in a responsible manner. Once cleaned, the squeegee blade is transported back at 66 to the squeegee blade stockroom 62, where the squeegee blade is ready to be used during the same or different production run.

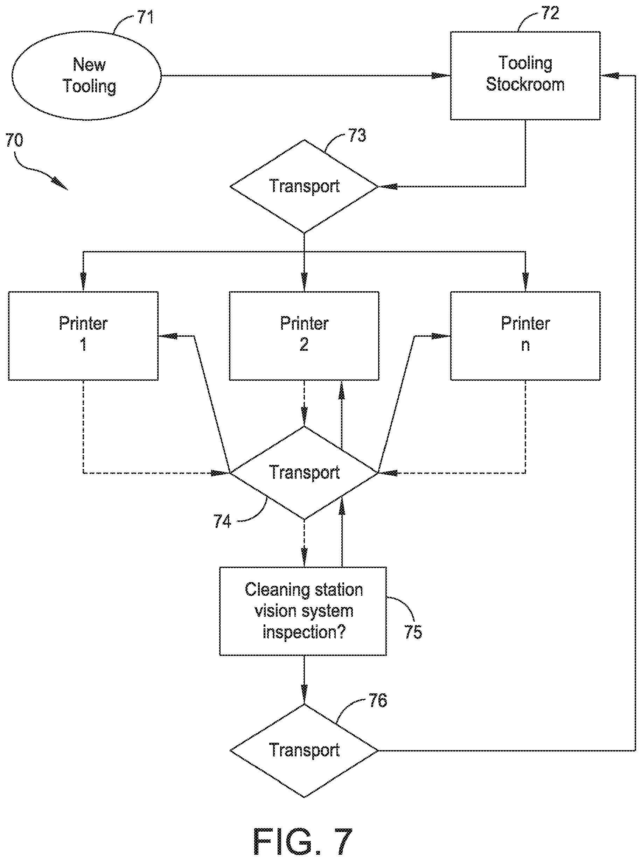

Referring to FIG. 7, a method of replacing tooling used to support a substrate in a print position is generally designated at 70. As shown, when a request for a new tooling is made at 71, either for a new production run or because of a defect detected with existing tooling, new tooling is retrieved from a tooling stockroom at 72 and transported at 73 to one of several stencil printers identified by "Printer 1," "Printer 2" and "Printer 3." The stencil printers can be part of a single production line used to fabricate printed circuit boards or part of several production lines. The number of stencil printers can vary. At the production line, the used tooling is removed from the stencil printer and the new tooling is inserted into the stencil printer and secured for use. The used tooling is transported at 74 to a station 75 where the tooling is inspected, and if salvageable, cleaned for reuse. If defective, the tooling is scrapped in a responsible manner. Once cleaned, the tooling is transported back at 76 to the tooling stockroom 72, where the tooling is ready to be used during the same or different production run.

### Movable Cart

Embodiments of the present disclosure are directed to a delivery system that is configured to automate a changeover process for a stencil printer and to implement one or more of the methods described with reference to FIGS. 4-7. In one embodiment, the delivery system includes a movable cart that is configured to engage a stencil printer to supply and receive replacement and replenishment parts and materials to the stencil printer. For example, the stencil printer may include a docking station that is configured to receive the movable cart. The docking station may include an interface that enables the movable cart to communicate with the stencil printer. A single movable cart may be configured to include changeover stencils, replacement stencils, replacement solder paste cartridges, replenishment solder paste cartridges, replacement squeegee blades, replenishment squeegee blades, and replacement support tooling. During a changeover, for example, the stencil printer must be reconfigured to produce different items. Thus, a new stencil, a different type of solder paste, new blades having different lengths, and a new support tool to accommodate a different substrate may be employed within the stencil printer to produce a different product. Other items further may be replaced and/or replenished, such as paper and solvent used in stencil wipers.

The changeover process described herein can be achieved by a single movable cart that is configured to replace and/or replenish each item. In other embodiments, more than one movable cart can be provided. For example, for stencil changeover, the movable cart is configured to support a predetermined number of stencils. The movable cart and/or the stencil printer can be configured to identify the stencils, store the stencils, transport the stencils to and from the stencil printer, inspect the stencils, and interface with the stencil printer. The movable cart also may be configured to remove used parts, such as stencils, from the stencil printer.

The movable cart, or another movable cart, is configured to support a predetermined number of paste cartridges, which are selected for production runs anticipated for a particular day or a particular period of time. The movable cart and/or the stencil printer can be configured to identify the paste cartridges, store the paste cartridges in a suitable environment, transport the paste cartridges to and from the stencil printer, inspect the paste cartridges, and interface with the stencil printer. The movable cart also may be configured to remove used parts, such as paste cartridges, from the stencil printer. Moreover, the movable cart can be configured to store paste cartridges long term. In one embodiment, long term storage of solder paste can be achieved by refrigeration at 0 to 10 °C (32 to 50 °F). The paste cartridges can be stored at a location in the movable cart to maintain this temperature range. In another embodiment, the movable cart can be configured to pre-heat the paste cartridges prior to use to ready the cartridges for use in the stencil printer.

The movable cart, or another movable cart, is configured to support a predetermined number of squeegee blades, which are selected for production runs anticipated for a particular day or a particular period of time. The movable cart and/or the stencil printer can be configured to identify the squeegee blades, store the squeegee blades, transport the squeegee blades to and from the stencil printer, inspect the squeegee blades, and interface with the stencil printer. The movable cart also may be configured to remove used parts, such as squeegee blades, from the stencil printer.

The movable cart, or another movable cart, is configured to support a predetermined number of tooling used to support a printed circuit board in a print position, which is selected for production runs anticipated for a particular day or a particular period of time. The movable cart and/or the stencil printer can be configured to identify the tooling, store the tooling, transport the tooling to and from the stencil printer, inspect the tooling, and interface with the stencil printer. The movable cart also may be configured to remove used parts, such as tooling, from the stencil printer.

Embodiments of the present disclosure are further directed to a delivery system that is configured to automate a replenishment process for a stencil printer. In one embodiment, the delivery system includes a movable cart that is configured to engage a stencil printer to supply and receive replacement and replenishment parts and materials to the stencil printer. For example, the stencil printer may include a docking station that is configured to receive the movable cart. The docking station may include an interface that enables the movable cart to communicate with the stencil printer. A single movable cart may be configured to include changeover stencils, replacement stencils, replacement solder paste cartridges, replenishment solder paste cartridges, replacement squeegee blades, replenishment squeegee blades, and replacement support tooling. During a replenishment, for example, critical consumable products of the stencil printer must be replenished periodically. In one example, the solder paste cartridge requires replacement when depleted. Other items further may be replenished, such as paper and solvent used in stencil wipers.

The replenishment process described herein can be achieved by a single movable cart that is configured to replenish all replenishable items. In other embodiments, more than one movable cart can be provided. For example, for stencil replenishment, the movable cart is configured to support several replacement solder paste cartridges. The movable cart and/or the stencil printer can be configured to identify the replacement solder paste cartridge, store the cartridges, transport the cartridges to and from the stencil printer, inspect the cartridges, and interface with the stencil printer. The movable cart also may be configured to remove used items, such as spent cartridges, from the stencil printer.

The movable cart is configured to support several replacement squeegee blades. The movable cart and/or the stencil printer can be configured to identify the replacement squeegee blades, store the squeegee blades, transport the squeegee blades to and from the stencil printer, inspect the squeegee blades, and interface with the stencil printer. The movable cart also may be configured to remove used items, such as used or defective squeegee blades, from the stencil printer.

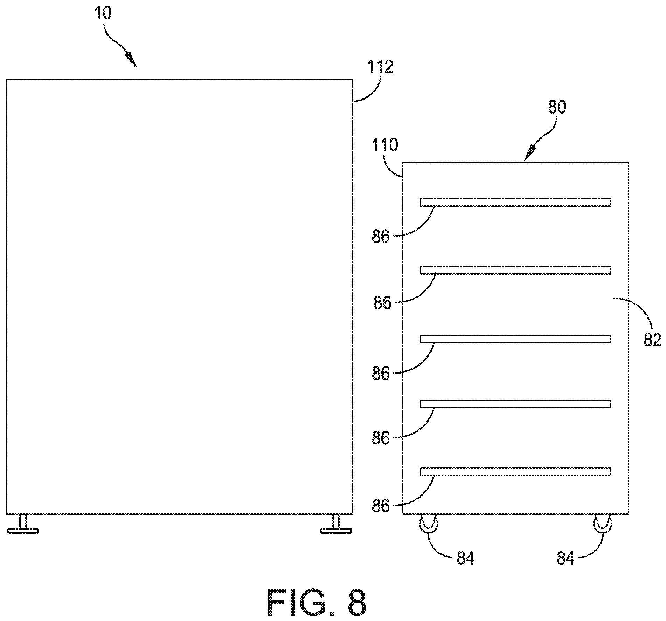

Referring to FIG. 8, in one embodiment, a movable cart, generally indicated at 80, includes a frame or housing 82 configured to support replacement and/or replenishment items. As shown, the frame 82 is generally rectangular and is supported on wheels or casters, each indicated at 84. In one embodiment, the movable cart 80 is configured to be manually moved by an operator by pushing the housing 82 of the movable cart. In this embodiment, the movable cart 80 can be configured with a push bar or a handle. In another embodiment, the movable cart 80 is configured to be automatically moved, either by remote control or by an automated control associated with the movable cart, the stencil printer 10, the production line, and/or some other dedicated control. In this embodiment, the movable cart 80 can include wheels that are driven by a suitable motor and drive train, and a control associated with the movable cart, the stencil printer 10, the production line, and/or some other dedicated control is configured to control the movable cart. The movable cart 80 further can include one or more sensors and/or a vision system, e.g., cameras, to guide the movable cart from a stockroom, for example, to the stencil printer.

The movable cart 80 includes one or more shelves, each indicated at 86, which are configured to store items for the stencil printer 10. For example, the shelves 86 can be specifically designed to support new and used stencils, new and spent/used paste cartridges, new and used squeegee blades, and new and used tooling. One or more shelves 86 can be configured to move vertically within the housing 82 to achieve a height suitable to operate with the stencil printer 10. Some shelves 86 may be designated as "clean shelves" to support clean or new items ready to be used within the stencil printer 10. Some shelves 86 may be designated as "dirty shelves" to support used items to be taken away from the stencil printer 10. The shelves 86 can be spaced apart from one another specific distances to receive various items. For example, the shelves 86 can be spaced apart 3/8-inch to 1½-inch from one another to accommodate stencil frame thicknesses.

The movable cart 80 can be configured with one or more devices used to transport items from the movable cart to the stencil printer 10 and from the stencil printer to the movable cart. For example, the device can include grippers to engage items, such as paste cartridges, to move a spent paste cartridge from the stencil printer to a tray of the movable cart 80 and to move a full paste cartridge from the movable cart to the stencil printer 10.

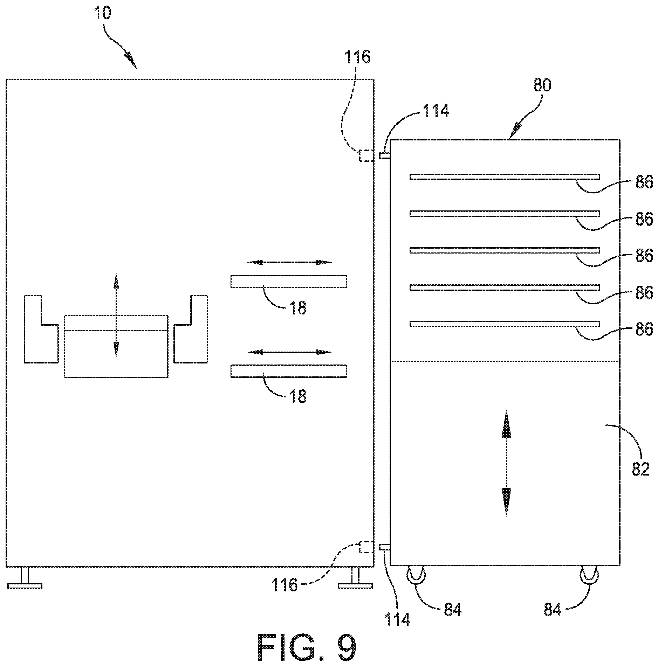

The movable cart 80 can be configured with an interface, which is designed to dock within a docking station provided on the stencil printer 10. In one embodiment, illustrated in FIG. 8, the movable cart 80 includes an interface 110, which is configured to dock within a docking station 112 of the stencil printer 10, both from a mechanic interface and an electronics communication interface. In a particular embodiment, the movable cart 80 can be configured with a unique mechanical interface that mates with a unique mechanical interface of the stencil printer 10. The unique mechanical interfaces can include geometric features. In another embodiment, illustrated in FIG. 9, the movable cart 80 can be configured with pins, each indicated at 114, that are received within guides, each indicated at 116, associated with the stencil printer 10 to register the movable cart with the stencil printer prior to fully docking the movable cart. Other types of guides can be used, such as electrical/magnetic guides, vision guides, sensors, latches, etc. The movable cart 80, when docked within the docking station of the stencil printer 10, can physically engage the stencil printer or be spaced from the stencil printer.

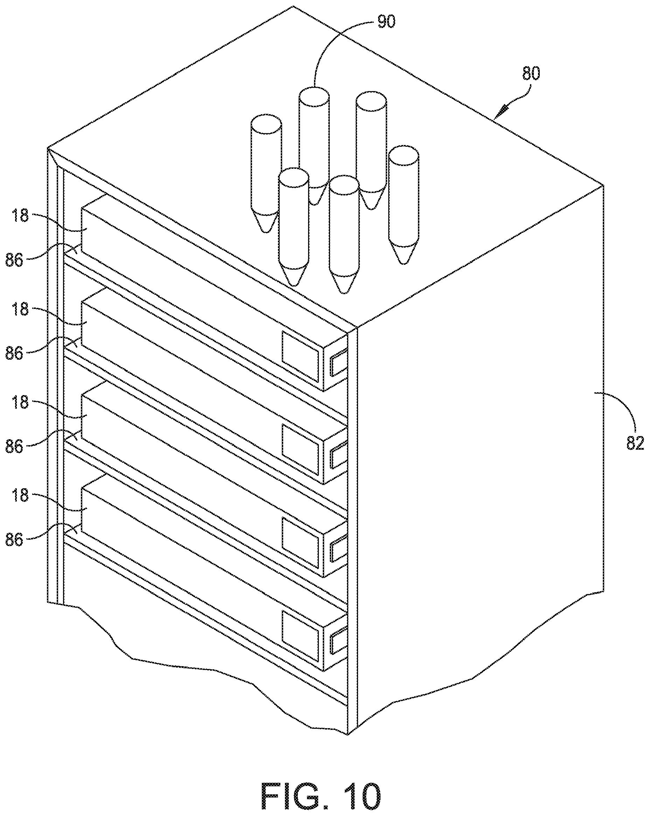

Referring to FIGS. 9 and 10, the movable cart 80 can be particularly suited to replace stencils, each indicated at 18, within the stencil printer 10. The shelves 86 are configured to support the stencils 18, which are shuttled into and out of the stencil printer 10. The shelves 86 can be configured to move in a vertical direction to achieve a desired elevation. The device, which will be described in greater detail below, associated with the movable cart 80 can be configured to move stencils 18 into and out of the stencil printer 10 from the movable cart once the stencil is at a desired elevation. The movement of the stencils 18 can be achieved automatically under the control of a controller associated with the movable cart 80, the stencil printer 10, and/or the production line. FIG. 10 illustrates the stencils 18 supported on the shelves 86 of the movable cart. FIG. 10 also illustrates the movable cart having support tooling 90, e.g., pins, on a top surface of the movable cart.

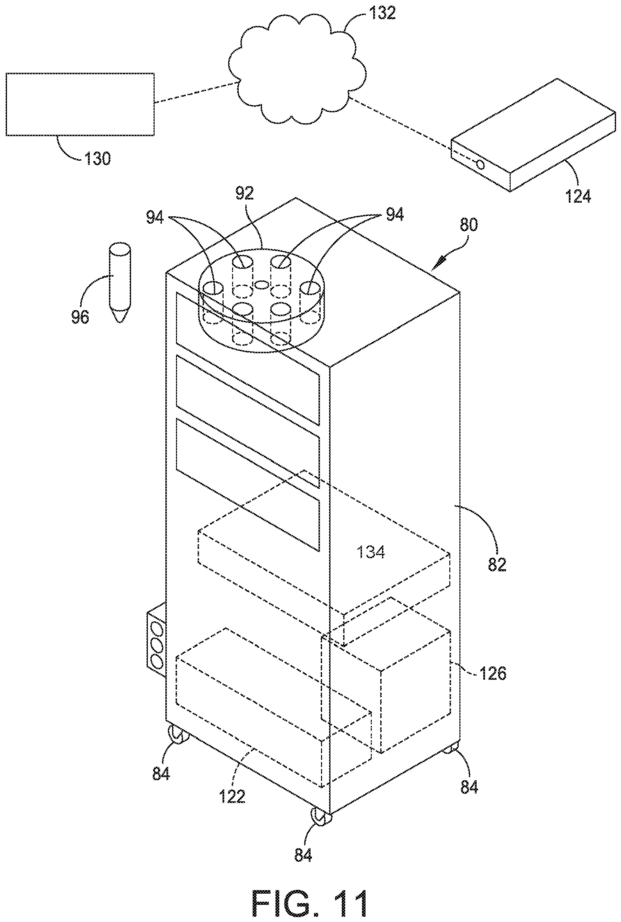

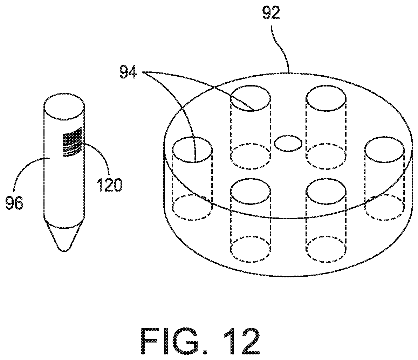

Referring to FIGS. 11 and 12, the movable cart 80 is particularly suited to replace other items within the stencil printer 10, such as paste cartridges. In one embodiment, the movable cart 80 includes a carousel wheel 92 having a plurality of open sockets, each indicated at 94, that are configured to support paste cartridges. An exemplary paste cartridge is indicated at 96 in FIG. 12. The carousel wheel 92 can be configured to rotate to present paste cartridges to the stencil printer 10. A device associated with the movable cart 80 can be configured to move paste cartridges into and out of the stencil printer from the carousel wheel 92 of the movable cart. The movement of the paste cartridges can be achieved automatically under the control of a controller associated with the movable cart 80, the stencil printer 10, and/or the production line.

In one embodiment, the movable cart 80 can be configured to locate and reach a paste dispenser at a rear of print head of the stencil printer 10. The carousel wheel 92 containing paste cartridges is positioned on a face of the movable cart 80 in which an index mechanism associated with the carousel wheel presents a new paste cartridge. A pinch roller can be provided to rotate the paste cartridge and to read/verify a predetermined identification mark 120 (FIG. 12) provided on the paste cartridge. In one embodiment, the predetermined identification mark 120 can be a bar code, which is configured to be read by the imaging system 30 or by an imaging system associated with the movable cart 80. In another embodiment, the predetermined identification mark can embody an RFID tag that is read by a reader. Used paste cartridges can be deposited within the open sockets 94 provided in the carousel wheel 92.

Referring back to FIG. 11, in one embodiment, the movable cart 80 includes wheels 84 that are driven by a suitable motor and drive train indicated at 122, and a control, such as a remote control 124 configured to control the movement of the movable cart. The movable cart 80 further includes a power source 126, for example a battery, to power the movement of the movable cart via the motor and drive train 122.

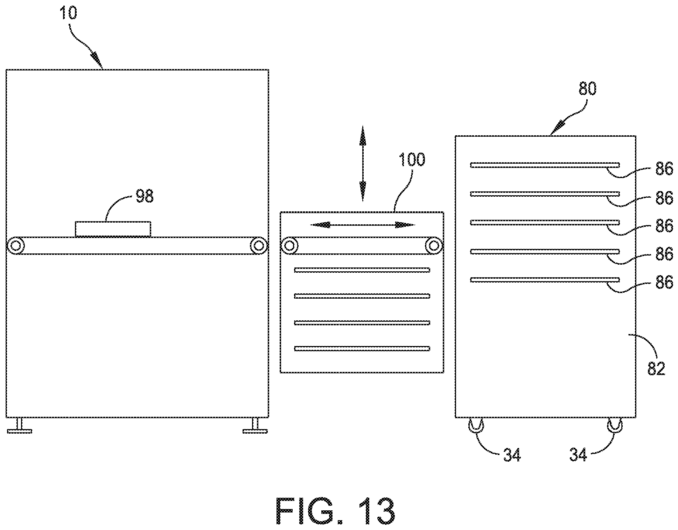

Referring to FIG. 13, the movable cart 80 is configured to deliver and remove tooling 98 from the stencil printer 10. In the shown embodiment, a conveyor assembly 100 is positioned between the movable cart 80 and the stencil printer 10. The conveyor assembly 100 can be a dedicated conveyor or part of the conveyor system for the stencil printer 10. The shelves 86 of the movable cart 80 are configured to support tooling 98 and position the tooling at a desired elevation. Similarly, the conveyor assembly 100 is configured to receive tooling 98 from the movable cart 80 at a desired elevation and transfer the tooling to the stencil printer 10. The conveyor assembly 100 is further configured to receive tooling 98 from the stencil printer 10 at a desired elevation and transfer the tooling back to the movable cart 80. For example, during a changeover operation, new tooling 98 may be required. The movable cart 80 and the conveyor assembly 100 are configured to remove tooling 98 from the stencil printer 10 and transfer the used tooling to the movable cart via the conveyor assembly. New tooling 98 is removed from the movable cart 80 and transferred to the stencil printer 10 via the conveyor assembly 100.

In some embodiments, when changing a stencil within the stencil printer 10, the movable cart 80 can be configured to verify a new, correct stencil on the movable cart, position the used stencil on an empty shelf 86 of the movable cart, position the new, correct stencil within the stencil printer in a proper position and orientation.

In some embodiments, movable cart 80 can be configured to clean squeegee blades by cleaning or otherwise removing used paste from the squeegee blades.

In some embodiments, the movable cart 80 can be configured to change used squeegee blades by unclamping squeegee blades from the print head 20 and positioning the used squeegee blades on an open shelf 86 of the movable cart. New squeegee blades are taken from the movable cart 80 and mounted on the print head 20 of the stencil printer 10.

In some embodiments, the movable cart 80 includes a controller that is adapted to control the operation of the movable cart based on operational parameters obtained by the controller. The controller can be configured to communicate with the controller 14 of the stencil printer 10 and/or a controller associated with the production line. In one embodiment having multiple movable carts 80, the controller may embody a plurality of controllers provided in each movable cart that communicates with one another over a controller area network (CAN) Bus or other type of network. In other embodiments, a master controller may be provided to control the operation of the controllers of the movable carts 80. Each movable cart 80 may be provided with a display, which is operably coupled to the controller. The display is adapted to display the operational parameters of the movable cart, such as, but not limited to, the number of clean and used stencils, the number of full and spent/used paste cartridges, the number of new and used squeegee blades, and/or the number of new and used tooling. Suitable monitors may be provided to acquire such information. Alternatively, or in addition to the foregoing embodiment, the operational parameters may be displayed on the display 16 provided within the stencil printer 10 and/or a display associated with the production line.

In other embodiments, the movable cart 80 may be controlled by the controller 14 of the stencil printer 10 and/or a controller associated with the production line. The controller can be a controller dedicated to one or more movable carts 80.

In some embodiments, material identification for items on the movable cart 80 can include a device to manipulate the item and a scanner to scan and identify the item. For example, for paste cartridges 96, the movable cart 80 can be configured to include a pinch wheel to rotate the paste cartridge to align a code or predetermined identification mark provided on the paste cartridge with scanner provided on the movable cart. The system is configured to tie material identification associated with the paste cartridge 96 to a recipe, production time, etc., for the stencil printer 10. In one embodiment, a barcode to identify the items can be implemented. For example, the barcode can include a 1D scanner for UPC codes, a 2D scanner for QRC codes, a printed label applied on the item or a laser etched label etched on the item. In another embodiment, an RFID system to identify the items can be implemented. For example, the RFID system can include an RFID tag applied to the item and an RFID reader associated with the movable cart 80. With an RFID system, line-of-site between the reader and the item is not required. Moreover, scanning is not required to identify all items within the movable cart 80. In another embodiment, an imaging or vision system to identify the items can be implemented. The vision system could be an imaging system similar to the imaging system 30 associated with the stencil printer 10, and can be associated on the stencil printer, off the stencil printer or on the movable cart 80.

In some embodiments, a database is provided to keep track of items stocked on the movable cart 80. In one embodiment, the database may include an open application (App) architecture and be configured to push data to the stencil printer 10. The movable cart 80 can be configured to communication with the stencil printer 10 to push/pull data to stencil printer and/or the production line or configured to communicate with the production line directly. The database can include job information or material information. The database further can communicate with a manufacturing execution system (MES) associated with the production line, the stencil printer 10, or both. The MES system can be configured to know which materials are required for a production run. The movable cart 80 can be configured to communicate with the MES system to adjust delivery of items to the stencil printer 10.

The database further can be configured to retrieve information about items based on identification, e.g., a barcode number. In one embodiment, a central management system can be provided in which the stencil printer 10 and/or the movable cart 80 is programmed to accept material coming from movable cart. The movable cart 80 is programmed to update the database to identify the materials on the movable cart, load information into the database associated with the movable cart and/or the stencil printer 10 from a network, which is tied back to the MES system.

The database further can be configured to store additional information, such as usage and consumption. The database can be configured to store information locally or remotely, and can be configured to store data associated with one or more production runs. For example, the database can be configured to obtain and store data including but not limited to traceability of stencils, paste cartridges, squeegee blades and tooling, paste usage, cycles, etc.

The database can be configured to share prediction data when replacement/replenishment is needed. For example, with respect to storing information related to paste cartridges, the database can be configured to perform one or more of the following: store information on when paste cartridges need replenishment; perform a certain function if a paste cartridge is low on paste; trigger an alarm and/or a report that the paste cartridge is low; signal to an inventory control system associated with the stencil printer 10 and/or the production line; perform analytics on consumable usage based on operating parameters and actual use and upstream/downstream equipment activity; predict changeout or maintenance (on the stencil printer and/or on the movable cart 80); and correlate over multiple sites to predict when to switch out paste cartridges. The database can be configured to share prediction data for other changeable/consumable items, such as for the stencils, paste cartridges, squeegee blades and tooling.

The database can be configured to store data associated with lot traceability. In addition, RFID or mechanical keying of a board or a stencil frame of the stencil is provided to ensure correct alignment/orientation/direction/front-back/top-bottom when these items are inserted into the stencil printer 10. This information can be used to verify correct orientation and/or fit before the items are transported from the warehouse and/or before the items are installed in the stencil printer 10. A low-cost reader can perform this function.

Referring back to FIG. 11, in one embodiment, the remote control 124 can be configured to communicate with a database 130 via the cloud 132 or ISP to provide the functions described above. In another embodiment, the database 130 can be part of a computer control system for the stencil printer 10 or the movable cart 80 or a production line.

In some embodiments, the movable cart 80 can be configured to store materials. The movable cart 80 can be configured to be flexible to accommodate where the materials come from and where the materials go to. In addition, the movable cart 80 can be configured to identify where a particular material is located on the movable cart. In certain embodiments, the location, whether by auto delivery or manual delivery, is remote, local, on the movable cart 80, and/or on the stencil printer 10. As mentioned above, the movable cart 80 can be configured to control environmental parameters. For example, the movable cart 80 can be configured to control temperature for paste contained within paste cartridges by chilling stored paste cartridges, heating paste cartridges ready for use, and chilling paste cartridges that have been used, but still retain paste. In one embodiment, the housing 82 can be insulated and a cooling/heating unit 134 (FIG. 11) can be provided to cool or heat the interior of the housing and thus the paste cartridges. The movable cart 80 further can be configured to predict when to start heating/chilling paste cartridges based on upcoming production, track time for shelf life, and individually control each paste cartridge to proper temperature and at correct time. In other embodiments, the movable cart 80 can include a cartridge shooter to move paste cartridges. The movable cart 80 further can be configured to control humidity to avoid condensate. The movable cart 80 further can be configured to operate in a clean environment, e.g., a standard mechanical interface (SMIF) environment.

In some embodiments, the movable cart 80 can be configured to perform inventory control. Specifically, the movable cart 80 can be configured to identify where material is located, how much material is used, how the material is used, when the material is used, tie the material and information about the material to a customer inventory control system, and track material type consumed per board or lots of boards.

In some embodiments, the movable cart 80 can be configured to organize items stored on the movable cart. As mentioned above, in one embodiment, one movable cart 80 can be provided to store, transport and deliver multiple resources, including but not limited to stencils, paste cartridges, squeegee blades and tooling. In another embodiment, the movable cart 80 can be configured to store, transport and deliver a single resource or item to the stencil printer 10. For example, the movable cart 80 can be configured to store multiple stencils. The movable cart 80 can be configured to service multiple production lines. In another embodiment, the movable cart 80 can be configured to service one stencil printer 10.

In some embodiments, the movable cart 80 can be configured to transport items from the movable cart to the stencil printer 10 and from the stencil printer to the movable cart, and be able to account for elevation differences between the movable cart and the stencil printer. The transportation can be automated or manual. In one embodiment, movable cart 80 can be moved by automatically guided vehicle (AVG) technology associated with the movable cart or remotely controlled. In another embodiment, the movable cart 80 can be configured to move autonomously. In another embodiment, the movable cart 80 can be configured to be moved manually. In yet another embodiment, the movable cart 80 can be configured to move items stored on the movable cart automatically and/or manually. For example, the movable cart 80 can be configured to move items automatically, and can provide for an interruption of a pre-planned activity in which the items are moved manually.

In some embodiments, timing associated with performing transportation functions of the movable cart 80 can be programmed to account for shift change, e.g., a personnel shift, scheduled maintenance, on demand activities, e.g., a recipe change, and predictive events (just-in-time replacements). The timing can be programmed to meet multiple line balance control requirements, with one or more movable carts 80 and to meet real-time on-demand material supply demands on the production line.

In some embodiments, the movable cart 80 is configured to perform inspection. For example, the movable cart 80 can inspect on cart and off cart items including stencils, paste cartridges, squeegee blades, and tooling. In one embodiment, a vision system associated with the movable cart can be configured to obtain images of the items. The vision system in conjunction with the controller, can be configured to inspect for cleanliness, damage, wear, and identification readability, e.g., is the barcode label worn, dirty or torn. The vision system can embody any type of 2D, 3D or color camera.

In some embodiments, the movable cart 80 is configured to interface with the stencil printer 10, both from a mechanic interface and an electronics communication interface. In one embodiment, the movable cart 80 can be configured with a unique mechanical interface that mates with a unique mechanical interface of the stencil printer 10. The unique mechanical interfaces can be geometric features. In another embodiment, the movable cart 80 can be configured with pins that are received within guides associated with the stencil printer 10 to register the movable cart with the stencil printer prior to fully docking the movable cart. The pins and guides can be reversed, with the pins provided on the stencil printer 10 and the guides provided in the movable cart 80. Other types of guides can be used, such as electrical/magnetic guides, vision guides, sensors, latches, etc.

In some embodiments, the interface and the docking station can be configured with a clamping system to maintain the movable cart 80 in place with respect to the stencil printer 10. For example, a magnetic clamping system can be employed.

In some embodiments, the stencil printer 10 can be configured with multiple docking stations, e.g., five docking stations. The docking station can be provided at a front of the stencil printer 10 or at a back of the stencil printer.

The movable cart 80 and/or the stencil printer 10 can be configured to verify whether the movable cart can be docked and interface with the stencil printer. In one embodiment, verification can be provided to confirm that the movable cart 80 is in position and ready to interface with the stencil printer 10. This verification process can further determine whether correct materials are on the movable cart 80 and whether the movable cart material information can be received from MES system, or locally identified. If not correct, the movable cart 80 can be configured to activate an alarm and/or alert an operator if wrong or damaged materials are on the movable cart.

In some embodiments, the movable cart 80 can be configured with actuation devices or actuators to move items onto and off of the movable cart once the movable cart is docked to the stencil printer 10. Embodiments of the actuators can be implemented on the movable cart 80, the stencil printer 10 or both. In another embodiment, the items can be manually loaded and unloaded from the movable cart 80.

In some embodiments, the movable cart 80 can be configured to interface with a production line. With this embodiment, the operator of the production line can confirm the correct location and acknowledge receipt of the movable cart 80 on the stencil printer 10.

In some embodiments, the movable cart 80 can be configured to communicate with the stencil printer 10, the production line, and/or select machines within the production line via an open platform. Communication systems can include a wired system, a wireless system (through a common network, mesh, Bluetooth, Wi-Fi, Zigbee, WAN, Nodes, Li-Fi, etc.), a combination of wired and wireless systems, and infrared (IR) system.

In some embodiments, the movable cart 80 can be configured with a dedicated power source. In one embodiment, the movable cart 80 includes a battery configured to power automated components provided in the movable cart, e.g., mechanisms used to move stencils into and out of the movable cart, mechanisms used to move paste cartridges into and out of the movable cart, mechanisms used to move squeegee blades into and out of the movable cart, and mechanisms used to move tooling into and out of the movable cart. In other embodiments, the movable cart 80 can be configured with an uninterruptible power supply. The power source can be configured to support actuation while "docked" (high-voltage from stencil printer when docked, otherwise low-voltage when undocked). The power source can be configured to recharge for autonomous operations, e.g., recharge a battery from power provided by the stencil printer 10.

In some embodiments, the movable cart 80 can be configured to function with the stencil printer 10. For example, the movable cart 80 can be configured to provide a handshaking function with the stencil printer 10 prior to a transfer of an item, e.g., "please give me stencil #1234." The movable cart 80 and the stencil printer 10 can be configured with a communication protocol and/or a library reference on what is available to consume. The movable cart 80 can be configured to determine whether the movable cart has correct items. The handshaking function can be configured to ensure the correct transfer of an item, e.g., "here's stencil #1234," and/or the subsequent transfer of an item, e.g., "I now have stencil #1234." In one embodiment, a mobile device can be configured to scan and identify items in the movable cart 80, and determine, for example, whether the items are ready for use, require cleaning, etc.

In some embodiments, the movable cart 80 can be configured to address errors associated with handling and recovering items in the movable cart. For example, the movable cart 80 can be configured to detect an incomplete action by one party, an incomplete transfer of an item, e.g., a stuck or jammed item, a dropped transfer, e.g., "I passed stencil #1234 to you, don't you have it?," and a manual intervention or override, e.g., "here, let me help you." In one embodiment, a controller associated with the movable cart 80 can be configured to perform static discharge control, data recovery and/or security.

In some embodiments, the movable cart 80 can be configured with a higher level of capability. In addition to indexing all the equipment to the correct height, the movable cart 80 would need to pull in/push out all equipment for machine gantries to attach.

In some embodiments, existing machine gantries, rails and print head of the stencil printer 10 can be configured to shuttle items in and out.

In some embodiments, the print head 20 of the stencil printer 10 can be configured to lift and shuttle a tooling plate.

In some embodiments, the movable cart 80 can be configured with a paste cartridge indexer at a top of the movable cart to load/unload paste cartridges.

In some embodiments, the movable cart 80 can be configured to communication with the stencil printer 10, the production line and a warehouse associated with the production line.

In some embodiments, the movable cart 80 can be configured with an electrical/pneumatic interface.

In some embodiments, the movable cart 80 can be configured to track consumables - new and used on the movable cart, e.g., solder paste cartridges, including location, temperature and other data.

In some embodiments, the movable cart 80 can be configured to store and supply stencils for duration of a production run.

In some embodiments, the movable cart 80 can be configured to verify and ensure that the squeegee blades are associated with a stencil to ensure compatibility of parts during a changeover.

In some embodiments, the squeegee blades can include disposable blades that are plastic molded blade.

In some embodiments, the movable cart 80 can be configured to scan all consumables with a suitable scanning device, such as a barcode reader or RFID reader.

In some embodiments, the movable cart 80 can be configured with an indexing mechanism to properly locate consumables.

In some embodiments, the movable cart 80 can be configured with a bypass switch to disconnect the movable cart from the stencil printer 10 if the movable cart has an issue.

In some embodiments, the movable cart 80 can be configured to be moved manually or by an automated guided vehicle (AGV).

In some embodiments, the movable cart 80 can be configured to dock and interface with the stencil printer 10.

In some embodiments, the movable cart 80 can be configured to service multiple stencil printers 10.

In some embodiments, the movable cart 80 can be configured to be dedicated to one consumable item, e.g., stencils, or multiple consumable/changeover items.

In some embodiments, the movable cart 80 can be configured to transport and present the consumables to be cleaned at a remote station.

In some embodiments, the movable cart 80 can be configured to be refilled at a stockroom associated with a warehouse.

In some embodiments, the movable cart 80 can be configured to be climate controlled, either actively or passively.

In some embodiments, the movable cart 80 can be configured be controlled by an application (App) capable for smartphone integration.

### Robotic Arm

As mentioned above, a device may be provided to perform the transfer functions between the movable cart 80 and the stencil printer 10. This device may embody a robotic arm that is either associated with the stencil printer 10 and/or the movable cart 80. The robotic arm is configured to perform many functions, including but not limited to removing and installing stencils, paste cartridges, squeegee blades, and tooling. The robotic arm may include an independent controller, or be controlled by the apparatus on which the robotic arm is mounted, i.e., the stencil printer 10 or the movable cart 80.

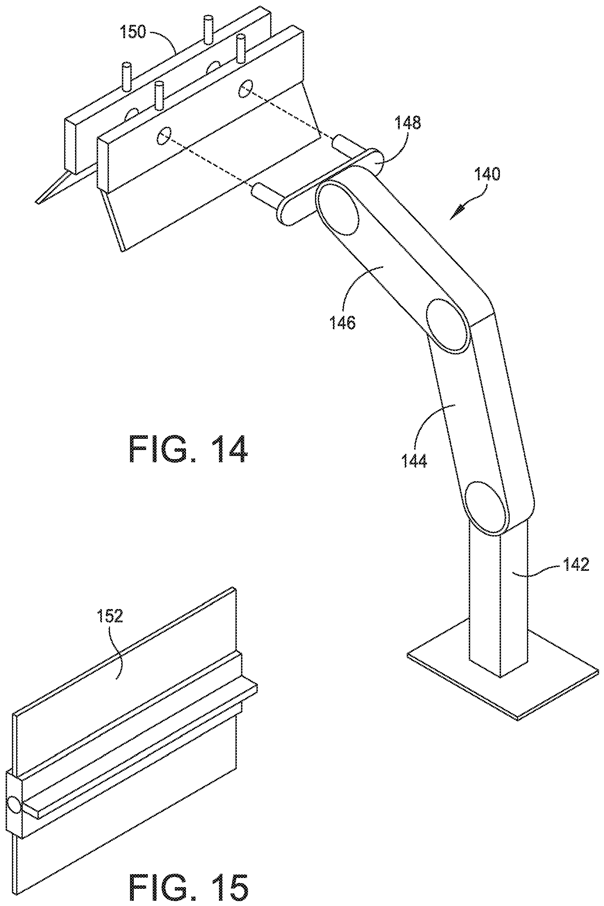

Referring to FIG. 14 a robotic arm is generally indicated at 140. In the shown embodiment, the robotic arm 140 includes a plurality of articulated segments 142, 144, 146 that can move a device 148, which is attached to the robotic arm at the end of the robotic arm in a desired direction. In one embodiment, the robotic arm 140 includes a base segment 142, which is removably connected to the frame or housing of a support structure in a suitable manner. For example, the base segment 142 may be secured to an inner surface of a cover of the stencil printer 10 so that the robotic arm 140 operates within the stencil printer. In another embodiment, the base segment 142 may be secured to a suitable surface provided on the frame 82 of the movable cart 80. In one embodiment, the base segment 142 is configured to rotate about an axis perpendicular to a surface on which the base segment is mounted. In another embodiment, the robotic arm 140 can be configured with additional segments.

An opposite end of the base segment 142 is rotatably connected to a first articulating segment 144, which in turn is rotatably connected to a second articulating segment 146. The device 148 is secured to the second articulating segment 146 at the end of the second articulating segment. The arrangement is such that the robotic arm 140, under the control of the controller, can be articulated to position the device 148 in a desired direction to perform an operational function. The segments 142, 144, 146 are secured to one another by suitable connectors that enable one segment to be articulated with respect to its adjacent segment. For example, a ball and joint or a universal joint connector can be provided.

In one embodiment, shown in FIG. 14, the device 148 is configured to be secured to a squeegee blade assembly 150. In this embodiment, the squeegee blade assembly 150 includes two separate blades in which solder paste is deposited between the blades. The device 148 also can be configured to be secured to any type of blade assembly, such as the squeegee blade assembly 152 shown in FIG. 15.

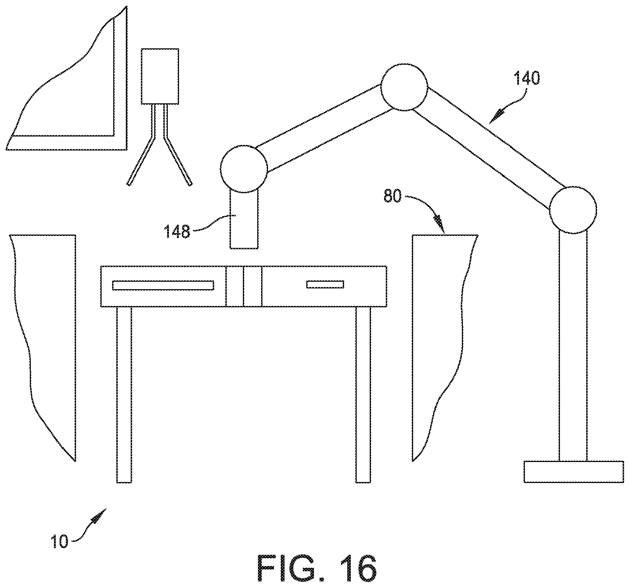

Referring to FIG. 16, in another embodiment, the robotic arm 140 is configured to operate within the stencil printer 10 from the movable cart 80. The device 148 attached to the end of the robotic arm 140 can be configured to transfer stencils, paste cartridges, squeegee blades, and/or tooling to and from the stencil printer. The device 148 of the robotic arm 140 is operated under the control of the controller associated with the robotic arm, the stencil printer 10 and/or the movable cart 80.

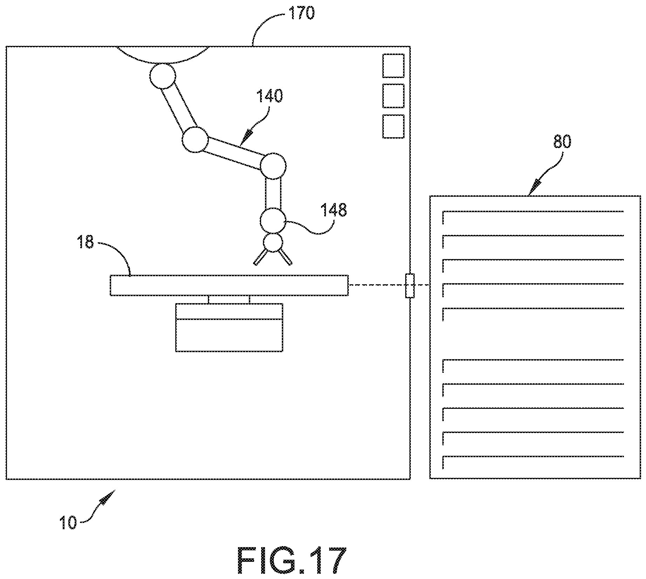

Referring to FIG. 17, in another embodiment, the robotic arm 140 is mounted within the stencil printer 10. As described above, the robotic arm 140 is mounted on an inner surface of a cover 170 of the stencil printer 10. The robotic arm 140, in addition to performing the transfer function of moving items into and out of the stencil printer 10 from the movable cart 80, for example, can be configured to perform the print function within the stencil printer. For example, the device 148 mounted at the end of the robotic arm 140 can include a print head having a supply of solder paste and squeegee blades to print material on the stencil 18 during a print operation. The device 148 can include other items as well.

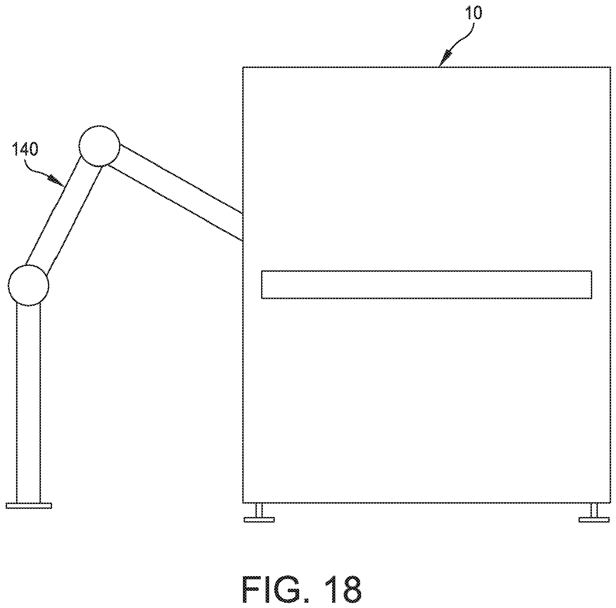

Referring to FIG. 18, in another embodiment, the robotic arm 140 can be mounted at a location outside the stencil printer 10. With this embodiment, the robotic arm 140 can perform the same functions described with reference to the robotic arm 140 illustrated in FIG. 17.

In some embodiments, the robotic arm 140 is mounted on an inner surface of a cover of the stencil printer. The robotic arm 140 includes several joined arm segments 142, 144, 146 and a device 148, e.g., a gripper device, and enables multi-axis movement. In one embodiment, the robotic arm 140 can be telescopic and able to extend and retract upon command. In one embodiment, the robotic arm 140 further includes a vision system, e.g., a camera, mounted at an end of the robotic arm adjacent to or on the device 148 to inspect items retrieved from the movable cart 80 or items used on the stencil printer 10, e.g., damage to squeegee blades, tooling, stencil orientation, etc. In one embodiment, the robotic arm 140 can be configured to include a variety of end effectors that are used to transfer items to and from the movable cart. In one embodiment, instead of being mounted to the stencil printer 10, the robotic arm 140 can be configured to be located remote from stencil printer 10, e.g., the robotic arm can mounted on the movable cart. In this embodiment, the robotic arm 140 can be configured to retrieve and deliver items to a stockroom.

In some embodiments, the robotic arm 140 is configured to perform squeegee function since the arm segments enable infinite degrees of freedom of movement for rake and attack angle. In addition, the robotic arm 140 further is configured to dispense solder paste on the stencil 18 prior to performing a squeegee function.

In some embodiments, the gripper device 148 of the robotic arm 140 can be configured to pick up items from the movable cart 80 and return used or spent items back on the movable cart. In this embodiment, the robotic arm 140 is configured to perform a changeover function in which items, such as stencils, paste cartridges, squeegee blades and tooling, are removed from the stencil printer 10 and returned to the movable cart 80 and new items are mounted within the stencil printer. The robotic arm 140 can be configured to verify that all replaced items on the stencil printer 10 are correct. A vision system, e.g., a camera, associated with the robotic arm 140 can perform this function. The robotic arm 140 is further configured to perform other functions including but no limited to scooping paste, cleaning blades, and placing used or spent items in a recycling receptacle.

In some embodiments, the robotic arm 140 can be configured to localize replenishment of solder paste within a paste cartridge. In one embodiment, a vision system, e.g., a camera, associated with the robotic arm 140 identifies where paste is low within the paste cartridge. This may be referred to as a paste height monitoring function.

In some embodiments, the robotic arm 140 can be configured to provide error handling and recovery. For example, the robotic arm 140 including a vision system, e.g., a camera, can be configured to determine whether there is a dropped or missing board, to verify whether board left in stencil printer 10, to determine board height monitoring using the camera or other sensors associated with the stencil printer, and to verify the item before loading the item. Other functions can be formed as well. For example, the robotic arm 140 can be configured to perform a paper change, solvent replenishment, all consumable replenishment, address local issues with blower/wipe and camera assist, and dedicated dispensing head/pick and place/cleaning.

As mentioned, the robotic arm 140 can be associated with the movable cart 80. For example, the robotic arm 140 can be configured to replace stencils, paste cartridges, squeegee blades and tooling. The robotic arm 140 can be configured to slide an old stencil 18 out of the stencil printer and slide a new stencil into the stencil printer. The robotic arm 140 can be configured to remove squeegee blades 150 or 152 from the stencil printer 10 and into a tray associated with the movable cart 80 and obtain new squeegee blades from the same or another tray associated with the movable cart into the stencil printer. The robotic arm 140 can be configured to remove tooling 98 from the stencil printer 10 and into a tray associated with the movable cart 80 and obtain new tooling from the same or another tray associated with the movable cart into the stencil printer. When employing the robotic arm 140, the tooling 98 can be made lighter to enable the robotic arm 140 to lift and move the tooling. The robotic arm 140 can be configured to replace items associated with the stencil printer 10.

In some embodiments, in addition to the movable cart 80, or independently from the movable cart, the stencil printer 10 can be configured with a robotic arm 140 to perform the transfer functions described with reference to the movable cart. In one embodiment, the robotic arm 140 replaces the print head 20 of the stencil printer 10 and is configured to be mounted on an inner surface of the 170 cover of the stencil printer.

In some embodiments, the robotic arm 140 would perform the squeegee wiping function and paste dispensing as needed.

In some embodiments, the robotic arm 140 is configured to transfer stencils, paste cartridges, squeegee blades and tooling to and from the movable cart 80 at a front or a back of the stencil printer 10.

In some embodiments, the movable cart 80 is configured to contain multiple stencils, paste cartridges, squeegee blades and tooling, and index them to a position where the robotic arm 140 could effectively remove them. As mentioned above with reference to the movable cart 80, the movable cart 80 would need to dock to the stencil printer 10 in a standard location to enable the robotic arm 140 to perform these functions.

In some embodiments, the robotic arm 140 can be configured to replace tooling within the stencil printer 10. In one embodiment, the robotic arm 140 is configured to remove tooling from the movable cart 80 with a device associated with the print head 20 of the stencil printer 10. The print head 10 positions over tooling, reaches down to secure the tooling, raises up with the tooling over the vision gantry 32, and places the tooling on a shelf 86 of the movable cart 80. New tooling is secured in place by reversing the steps.

In some embodiments, the robotic arm 140 can be configured to replace a calibration plate within the stencil printer 10.

In some embodiments, the robotic arm 140 includes a controller that is adapted to control the operation of the robotic arm based on operational parameters obtained by the controller. The controller can be configured to communicate with the controller of the stencil printer 10, the movable cart 80, and/or a controller associated with the production line.

In some embodiments, a device 148 of the robotic arm 140 can included a generic holder that is designed to snap-fit and connect replacement squeegee blades. The device 148 can be configured with side dams to fit any size of squeegee blade.

In some embodiments, the robotic arm 140 can be configured with a print head that is programmed to dispense solder paste with a first starting bead without squeegee, and to replenish with every print to maintain a consistent bead size.

In some embodiments, the robotic arm 140 can operate with a print head and without a print head.

In some embodiments, the robotic arm 140 can be configured with a grabbing tool that is mounted, e.g., screw mounted, on a head of the robotic arm.

In some embodiments, the robotic arm 140 can be mounted on an inner surface of the cover and configured to adjust an elevation of an end of the robotic arm to perform functions within the stencil printer 10.

In some embodiments, the robotic arm 140 is configured to lift and place heavy objects, such as tooling, and bulky objects, such as stencils, within the stencil printer. For example, the robotic arm 140 is configured to lift tooling from the movable cart 80 and place the tooling on the substrate support 28 of the stencil printer 10. In one embodiment, a top plate is swapped into and out of the stencil printer 10 and a base plate stays within the stencil printer.

In some embodiments, the robotic arm 140 can be configured to move a stencil with a device at the end of the robotic arm having a pin designed to engage the stencil.

In some embodiments, the robotic arm 140 can be configured with a vision system, e.g., a camera, to trace items being removed and installed within the stencil printer 10 and to verify orientation of such items.

In some embodiments, the robotic arm 140 can be is configured to remove squeegee blades and contain paste contamination within the stencil printer 10.

In some embodiments, the robotic arm 140 can be configured to remove excess paste from a top surface of the stencil.

### Machine Operator Managed Functions

In some embodiments, the operator of the stencil printer is responsible for storing changeover materials and consumable needs within a stockroom. As referenced, the operator is responsible for stocking the stencil, paste cartridge, squeegee blade and tooling stockrooms. The operator may also be required to store other consumable items, such as wiper paper and solvent used to clean the stencil.

In some embodiments, the operator is responsible for transporting some or all of the stocked items to and from the stencil printer. In one embodiment, a person, automated guided vehicle (AGV), or other robotic apparatus stocks the movable cart.

In some embodiments, the operator is responsible for docking the movable cart to the stencil printer.

As used herein, an "automated" or "fully automated" changeover describes the replacement or replenishment of an item without human intervention.

As used herein, a "partially automated" changeover describes the replacement or replenishment of an item with some or limited human intervention.

As used herein, "transport" or "transporting" describes moving an item from one position to another, either manually or with a machine.

As used herein, "install" or "installing" describes the process of placing an item in a position ready for use.

As mentioned above, the movable cart 80 and the robotic arm 140 can be employed to replace other items within the stencil printer 10. For example, the stencil wiper assembly 34 includes consumables, e.g., paper and solvent, which can be automatically replaced by the movable cart 80 and the robotic arm 140.

The concepts disclosed herein may be employed in other types of equipment used to fabricate electronic substrates, including dispensers, pick-and-place machines, reflow ovens, wave soldering machines, selective solder machines, inspection stations, and cleaning stations. For example, the concepts directed to replacing paste cartridges can be employed in dispensers used to dispense viscous material. In another example, the concepts directed to replacing tooling can be employed in dispensers and in pick-and-place machines used to mount electronic components onto electronic substrates. In another example, the concepts directed to replacing items can be employed in replacing solder within wave soldering and selective soldering machines and cleaning product within cleaning stations.

## Claims

1. An automated wheeled delivery cart configured to interface with a stencil printer to automate a changeover process for the stencil printer, comprising:
a housing configured to support replacement;
a robotic arm configured to remove and replace an item in a stencil printer; and
a controller configured to control the automated wheeled delivery cart to automatically move one or more replacement items from an item stocking location to the stencil printer,
wherein the housing is configured with an interface, which is configured to register with the stencil printer and configured to dock within a docking station provided on the stencil printer,
wherein the delivery cart is configured to be automatically moved, either by the controller or by a remote control or an automated control associated with the stencil printer, a production line, and/or a dedicated control, and;
wherein the robotic arm includes a gripping device mounted at an end of the robotic arm and a camera mounted at the end of the robotic arm adjacent to or on the gripping device, the camera being configured to inspect items retrieved from the delivery cart or items used on the stencil printer.

2. The automated wheeled delivery cart of claim 1, wherein the replacement item is a paste cartridge.

3. The automated wheeled delivery cart of claim 1, wherein the replacement item is a squeegee blade.

4. The automated wheeled delivery cart of claim 1, wherein the replacement item is a stencil.

5. The automated wheeled delivery cart of claim 1, wherein the automated wheeled delivery cart is configured to transport multiple replacement items.

6. The automated wheeled delivery cart of claim 1, wherein the automated wheeled delivery cart moves by automatically guided vehicle technology associated with the moveable cart, by remote control, or autonomously.

7. The automated wheeled delivery cart of claim 1, wherein the automated wheeled delivery cart includes one or more sensors or cameras to guide the cart from an item stocking location to the stencil printer.

8. The automated wheeled delivery cart of claim 1, wherein the robotic arm is configured to replace a paste cartridge, a squeegee blade, and a stencil in a stencil printer.

9. The automated wheeled delivery cart of claim 1, further comprising transporting multiple paste cartridges, squeegee blades, or stencils to the stencil printer.

10. The automated wheeled delivery cart of claim 1, wherein the automated wheeled delivery cart is configured to identify the replacement item.

11. The automated wheeled delivery cart of claim 1, wherein the automated wheeled delivery cart is configured to identify the replacement item and to retrieve information about the item based on the identification.

12. The automated wheeled delivery cart of claim 1, wherein the robotic arm includes a plurality of segments having a base segment removably connected to a support structure of the movable housing, a first segment connected to the base segment, and a second segment connected to the first segment, the gripping device being secured to the second segment, the robotic arm being telescopic to extend and retract the gripping device and the camera.

## Patentansprüche

1. Ein automatisierter Transportwagen mit Rädern, der so konfiguriert ist, dass er mit einem Schablonendrucker verknüpft wird, um einen Austauschvorgang für den Schablonendrucker zu automatisieren, aufweisend:
ein Gehäuse, das so konfiguriert ist, dass es einen Ersatz trägt;
einen Roboterarm, der so konfiguriert ist, dass er ein Element in einem Schablonendrucker entfernt und ersetzt; und
eine Steuerung, die so konfiguriert ist, dass sie den automatisierten Transportwagen mit Rädern so steuert, dass er automatisch ein oder mehrere Ersatzelemente von einem Elementlagerort zu dem Schablonendrucker bewegt,
wobei das Gehäuse mit einer Schnittstelle konfiguriert ist, die so konfiguriert ist, dass sie sich an dem Schablonendrucker registriert, und so konfiguriert ist, dass sie innerhalb einer an dem Schablonendrucker vorgesehenen Andockstation andockt,
wobei der Transportwagen so konfiguriert ist, dass er automatisch entweder durch die Steuerung oder durch eine Fernsteuerung oder eine mit dem Schablonendrucker, einer Produktionslinie und/oder einer dedizierten Steuerung assoziierte automatisierte Steuerung bewegt wird, und;
wobei der Roboterarm eine Greifvorrichtung, die an einem Ende des Roboterarms angebracht ist, und eine Kamera beinhaltet, die an dem Ende des Roboterarms angebracht ist, das an die Greifvorrichtung angrenzt oder sich an dieser befindet, wobei die Kamera so konfiguriert ist, dass sie die von dem Transportwagen erfassten Elemente oder die in dem Schablonendrucker verwendeten Elemente überprüft.

2. Automatisierter Transportwagen mit Rädern nach Anspruch 1, wobei das Ersatzelement eine Pastenkartusche ist.

3. Automatisierter Transportwagen mit Rädern nach Anspruch 1, wobei das Ersatzelement ein Wischerblatt ist.

4. Automatisierter Transportwagen mit Rädern nach Anspruch 1, wobei das Ersatzelement eine Schablone ist.

5. Automatisierter Transportwagen mit Rädern nach Anspruch 1, wobei der automatisierte Transportwagen mit Rädern so konfiguriert ist, dass er mehrere Ersatzelemente transportiert.

6. Automatisierter Transportwagen mit Rädern nach Anspruch 1, wobei sich der automatisierte Transportwagen mit Rädern durch eine Technologie für automatisch gesteuerte Fahrzeuge, die mit dem beweglichen Wagen verbunden ist, durch Fernsteuerung oder autonom bewegt.

7. Automatisierter Transportwagen mit Rädern nach Anspruch 1, wobei der automatisierte Transportwagen mit Rädern eine(n) oder mehrere Sensoren oder Kameras beinhaltet, um den Wagen von einem Elementlagerort zu dem Schablonendrucker zu führen.

8. Automatisierter Transportwagen mit Rädern nach Anspruch 1, wobei der Roboterarm so konfiguriert ist, dass er eine Pastenkartusche, ein Wischerblatt und eine Schablone in einem Schablonendrucker ersetzt.

9. Automatisierter Transportwagen mit Rädern nach Anspruch 1, ferner das Transportieren mehrerer Pastenkartuschen, Wischerblätter oder Schablonen zu dem Schablonendrucker aufweisend.

10. Automatisierter Transportwagen mit Rädern nach Anspruch 1, wobei der automatisierte Transportwagen mit Rädern so konfiguriert ist, dass er das Ersatzelement identifiziert.

11. Automatisierter Transportwagen mit Rädern nach Anspruch 1, wobei der automatisierte Transportwagen mit Rädern so konfiguriert ist, dass er das Ersatzelement identifiziert und auf Grundlage der Identifikation Informationen über das Element erfasst.

12. Automatisierter Transportwagen mit Rädern nach Anspruch 1, wobei der Roboterarm eine Vielzahl von Segmenten mit einem Basissegment beinhaltet, das entfernbar mit einer Tragstruktur des beweglichen Gehäuses verbunden ist, einem ersten Segment, das mit dem Basissegment verbunden ist, und einem zweiten Segment, das mit dem ersten Segment verbunden ist, wobei die Greifvorrichtung an dem zweiten Segment befestigt ist, wobei der Roboterarm teleskopisch ist, um die Greifvorrichtung und die Kamera auszufahren und zurückzuziehen.

## Revendications

1. Chariot de distribution automatisé à roues configuré pour servir d'interface avec une imprimante à stencil pour automatiser un processus de changement pour l'imprimante à stencil, comprenant :
un logement configuré pour supporter le remplacement ;
un bras robotique configuré pour retirer et remplacer un article dans une imprimante à stencil ; et
un dispositif de commande configuré pour commander le chariot de distribution automatisé à roues pour déplacer automatiquement un ou plusieurs articles de remplacement à partir d'un emplacement de stockage d'articles vers l'imprimante à stencil,
dans lequel le logement est configuré avec une interface, qui est configurée pour s'aligner avec l'imprimante à stencil et configurée pour se coupler dans une station d'accouplement fournie sur l'imprimante à stencil,
dans lequel le chariot de distribution est configuré pour être automatiquement déplacé, soit par le dispositif de commande, soit par une commande à distance ou une commande automatisée associée avec l'imprimante à stencil, une ligne de production, et/ou une commande dédiée, et ;
dans lequel le bras robotique comprend un dispositif de préhension monté sur une extrémité du bras robotique et une caméra montée sur l'extrémité du bras robotique adjacente au ou sur le dispositif de préhension, la caméra étant configurée pour inspecter des articles récupérés à partir du chariot de distribution ou des articles usagés sur l'imprimante à stencil.

2. Chariot de distribution automatisé à roues selon la revendication 1, dans lequel l'article de remplacement est une cartouche de pâte.

3. Chariot de distribution automatisé à roues selon la revendication 1, dans lequel l'article de remplacement est une lame de raclette.

4. Chariot de distribution automatisé à roues selon la revendication 1, dans lequel l'article de remplacement est un stencil.

5. Chariot de distribution automatisé à roues selon la revendication 1, dans lequel le chariot de distribution automatisé à roues est configuré pour transporter plusieurs articles de remplacement.

6. Chariot de distribution automatisé à roues selon la revendication 1, dans lequel le chariot de distribution automatisé à roues se déplace par une technologie de véhicule guidé automatiquement associée avec le chariot mobile, par une commande à distance, ou de manière autonome.

7. Chariot de distribution automatisé à roues selon la revendication 1, dans lequel le chariot de distribution automatisé à roues comprend un ou plusieurs capteurs ou caméras pour guider le chariot à partir d'un emplacement de stockage d'articles vers l'imprimante à stencil.

8. Chariot de distribution automatisé à roues selon la revendication 1, dans lequel le bras robotisé est configuré pour remplacer une cartouche de pâte, une lame de raclette et un stencil dans une imprimante à stencil.

9. Chariot de distribution automatisé à roues selon la revendication 1, comprenant en outre le transport de plusieurs cartouches de pâte, lames de raclette ou stencils vers l'imprimante à stencil.

10. Chariot de distribution automatisé à roues selon la revendication 1, dans lequel le chariot de distribution automatisé à roues est configuré pour identifier l'article de remplacement.

11. Chariot de distribution automatisé à roues selon la revendication 1, dans lequel le chariot de distribution automatisé à roues est configuré pour identifier l'article de remplacement et pour récupérer des informations concernant l'article sur base de l'identification.

12. Chariot de distribution automatisé à roues selon la revendication 1, dans lequel le bras robotisé comprend une pluralité de segments ayant un segment de base relié de manière amovible à une structure de support du logement mobile, un premier segment relié au segment de base, et un deuxième segment relié au premier segment, le dispositif de préhension étant fixé au deuxième segment, le bras robotisé étant télescopique pour étendre et rétracter le dispositif de préhension et la caméra.
